Europäisches Patentamt

European Patent Office

Office européen des brevets

(19)

(11) Numéro de publication : **0 057 646**
**B1**

(12) **FASCICULE DE BREVET EUROPÉEN**

(45) Date de publication du fascicule du brevet :
28.08.85

(51) Int. Cl.⁴ : **H 01 J 37/18**

(21) Numéro de dépôt : **82400176.2**

(22) Date de dépôt : **02.02.82**

(54) Ensemble de microscope électronique à balayage à fonctionnement in situ.

(30) Priorité : 04.02.81 FR 8102152

(43) Date de publication de la demande :
11.08.82 Bulletin 82/32

(45) Mention de la délivrance du brevet :
28.08.85 Bulletin 85/35

(84) Etats contractants désignés :
DE GB NL

(56) Documents cités :
EP-A- 0 022 356
FR-A- 1 367 468
FR-A- 1 480 912
FR-A- 2 046 833
PATENT ABSTRACTS OF JAPAN, volume 5, no. 141, 5
septembre 1981, page 813E73

(73) Titulaire : Etablissement Public dit: CENTRE NATIO-
NAL DE LA RECHERCHE SCIENTIFIQUE (CNRS)
15, Quai Anatole France
F-75007 Paris (FR)

(72) Inventeur : Jouffrey, Bernard Lab. d'Optique Elec. du
CNRS
29 Rue Jeanne Marvig B.P. 4347
F-31055 Toulouse Cedex (FR)
Inventeur : Trinquier, Jacques
8 Rue de L'Aubisque
F-31500 Toulouse (FR)
Inventeur : Franceschi, Jean-Luc
10 Rue Lamartine
F-31320 Castanet-Tolosan (FR)

(74) Mandataire : Pinguet, André et al
NOVAPAT - CABINET CHEREAU 107 Boulevard
Péreire
F-75017 Paris (FR)

EP 0 057 646 B1

Jouve, 18, rue St-Denis, 75001 Paris, France

## Description

La présente invention concerne les microscopes électroniques à balayage et, plus particulièrement, un microscope électronique à balayage à fonctionnement in situ.

L'utilisation des microscopes électroniques à balayage a connu, ces dernières années, un développement rapide en raison de leur souplesse d'utilisation, en association notamment avec des écrans cathodiques de visualisation, et de leurs performances extrêmement appréciables d'observation, notamment en ce qui concerne la profondeur de champ. Ces caractéristiques rendent les microscopes électroniques à balayage particulièrement avantageux, au plan industriel, pour le contrôle de surfaces de pièces structurelles ou opérationnelles, notamment pour le contrôle de procédés de fabrication ou l'étude de déformations de surfaces lors d'essais de contraintes. Jusqu'à présent, l'étude de telles surfaces était faite par des procédés optiques classiques utilisant des loupes ou des microscopes optiques, avec les inconvénients inhérents de faible grandissement, et surtout de profondeur de champ limitée. Il apparaît donc particulièrement tentant de mettre en œuvre, pour de tels contrôles, des microscopes électroniques à balayage en raison de leurs avantages évoqués ci-dessus. Or, on le sait, en microscopie électronique, il est nécessaire d'introduire l'objet à observer sur un support spécial pour le placer dans une enceinte sous vide formant chambre d'observation pour le microscope. De ce fait, l'utilisation de microscopes électroniques imposait jusqu'à présent le recours à des techniques de préparation destructive des pièces, nécessitant le prélèvement d'un échantillon susceptible d'être placé dans la chambre d'observation, au prix, le plus souvent, d'une détérioration ou d'une déformation redhibitoire de la zone à étudier.

Pour obvier à cet inconvénient, il a été proposé une technique d'observation au microscope électronique, utilisant une enceinte sous vide intermédiaire de faibles dimensions reliée à un dispositif de pompage puissant et débouchant au droit de la zone à observer par un diaphragme de très petite ouverture (de l'ordre de 30 microns) et de faible épaisseur, afin de limiter autant que faire se peut le débit de fuite d'air à compenser en permanence par le dispositif de pompage. La technique ainsi proposée souffre de nombreuses limitations, tenant notamment au champ très limité d'observation, du fait de la dimension microscopique du diaphragme, à la non-homogénéité du vide au niveau de l'axe optique ainsi qu'à la diffusion des électrons rétrodiffusés par l'objet entraînant une qualité médiocre des images.

La présente invention a précisément pour objet d'obvier à ces inconvénients en proposant un ensemble de microscope électronique à balayage fonctionnant in situ, de construction légère et transportable, qui puisse être posé directement sur l'objet à examiner sans préparation particulière de celui-ci, en autorisant une observation directe de l'objet en question dans son environnement naturel, en permettant d'obtenir de forts grandissements avec une profondeur de champ importante (par exemple de l'ordre de mille fois plus grande qu'avec un microscope optique) pour une étude rapide, souple et non destructive in situ par exemple d'ailes d'avion, ou pour le contrôle de pièces usinées ou travaillées avec précision, telles que des lentilles de verre ou des miroirs de systèmes optiques.

Pour ce faire, selon une caractéristique de la présente invention, l'ensemble de microscope électronique à balayage à fonctionnement in situ, comprenant une colonne de microscope électronique unitaire, des moyens de connexion à une installation de commande et de contrôle du microscope et à une installation de pompage, comporte un moyen de support de la colonne, relié à la partie inférieure de celle-ci, et définissant une chambre intérieure présentant une partie ouverte inférieure destinée à être placée en appui étanche sur une surface périphérique solidaire de la zone à observer.

Selon une caractéristique plus particulière de l'invention, le moyen de suppport comprend une paroi ou jupe périphérique résistant à la pression définissant la chambre intérieure et des moyens d'étanchéité souples délimitant la partie ouverte inférieure de la chambre et destinés à être appliqués sur la surface support à observer.

D'autres caractéristiques et avantages de la présente invention ressortiront de la description suivante d'un mode de réalisation, donné à titre illustratif mais nullement limitatif, faite en relation avec le dessin annexé sur lequel :

La figure unique est une vue schématique d'un ensemble de microscope électronique à balayage à fonctionnement in situ selon la présente invention positionné en appui étanche sur une surface à observer.

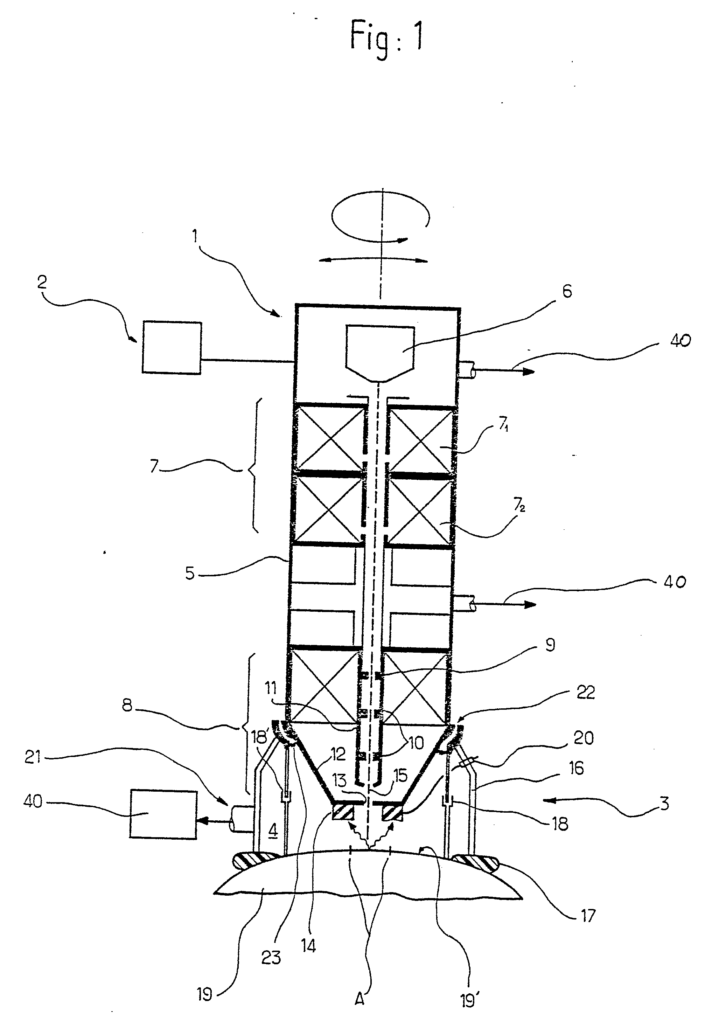

Comme représenté sur la figure 1, l'ensemble de microscope électronique à balayage à fonctionnement in situ selon l'invention comprend essentiellement une colonne de microscope électronique 1, de faibles dimensions et de poids réduit, reliée à une installation de commande et de contrôle électronique adéquate 2, un moyen de support de colonne 3 définissant une chambre intérieure 4, reliée ainsi que la colonne 1, à un dispositif de pompage puissant et portatif 40. De façon plus spécifique, la colonne 1 comprend un châssis tubulaire hermétique 5 renfermant, successivement, un canon à électron 6, un étage 7 de deux condenseurs $7_1$ et $7_2$, un étage de lentille objectif 8 avec un stigmateur 9 et des bobines de balayage 10 dans un conduit tubulaire 11 se prolongeant jusqu'au voisinage du fond d'un capot tronconique 12 convergeant vers le bas, fermant la colonne 1 et muni d'une ouverture centrale 13 de passage du faisceau électronique autour de laquelle est disposé le détecteur d'électrons annulaire 14 concentrique à l'axe optique 15 de la colonne 1.

Conformément à la présente invention, le moyen support 3 de la colonne 1 comprend une paroi ou jupe périphérique à résistance de forme 16 résistant à la pression, par exemple une virole en acier inoxydable, définissant la chambre intérieure 4, dans laquelle fait saillie le capot tronconique inférieur 12 et sur le bord de l'extrémité ouverte de laquelle est fixé un joint élastique périphérique 17, par exemple en matériau élastomère plein ou sélectivement gonflable. Le moyen de support comprend, en outre, un système de réglage en hauteur ou de vérins 18, 18', permettant de régler avec précision sur une plage déterminée la distance entre le détecteur 14 et la zone à observer A de la surface 19' du corps 19 à étudier. Un connecteur 20, monté dans la paroi 16, permet le raccordement du détecteur 14 à l'installation de commande et de contrôle 2. La paroi 16 comporte en outre, latéralement, un manchon 21 de raccordement au dispositif de pompage 40.

Dans un mode de réalisation particulier, pour permettre un débattement angulaire de la colonne 1 et couvrir ainsi une surface d'observation A plus grande, la colonne 1 est reliée à l'extrémité supérieure de la paroi support 16 par un système à rotule 22, par exemple à surfaces toriques coopérantes en téflon, l'étanchéité au niveau de la rotule 22 étant assurée par une membrane souple 23 en un alliage métallique connu sous l'appellation « Tombac » reliant de façon étanche la partie supérieure de la paroi 16 à une couronne adjacente du capot tronconique 12.

On comprendra donc que, pour l'observation in situ d'une pièce quelconque, on amène la colonne de microscope 1 avec son support 16 à l'aplomb de la zone A à étudier, l'ensemble prenant appui sur la pièce à étudier 19 par le joint souple 17, l'application du vide dans la chambre intérieure 4 du moyen de support par le dispositif de pompage 40 assurant dans celle-ci, le degré de vide (de l'ordre de $1,33.10^{-2}$ Pa, soit $10^{-4}$ mm de mercure) nécessaire pour le fonctionnement du microscope tout en plaquant en outre de façon parfaite le joint 17 sur la surface 19', assurant ainsi l'étanchéité requise pendant le temps nécessaire à l'observation. Ce dispositif permet ainsi l'étude, sur place, sans préparation préalable, d'ailes d'avion ou d'autres surfaces avec un pouvoir de résolution de l'ordre de 10 à 20 nanomètres.

La colonne de microscope 1, d'une hauteur approximative de 50 centimètres, est par exemple du type MIEL bis, mis au point par le laboratoire d'optique électronique du CNRS à Toulouse, et fonctionnant sous une basse tension de l'ordre de 10 à 15 kilovolts.

Quoique la présente invention ait été décrite en relation avec des modes de réalisation particuliers, elle ne s'en trouve pas limitée mais est au contraire susceptible de modifications et de variantes qui apparaîtront à l'homme de l'art. En particulier, pour l'observation de détails sur des surfaces d'aires limitées, la paroi 16 du moyen support peut être prolongée radialement vers l'intérieur par une couronne, elle-même terminée par le joint étanche 17, pour limiter l'ouverture de la chambre intérieure 4.

## Revendications

1. Ensemble de microscope électronique à balayage à fonctionnement in situ comprenant : une colonne de microscope unitaire ; et des moyens de connexion à une installation de commande et de contrôle du microscope et à une installation de pompage, caractérisé en ce qu'il comprend un moyen de support (16, 18) de la colonne (1), relié à la partie inférieure de celle-ci et définissant une chambre intérieure (4) résistant à la pression et présentant une partie ouverte inférieure, avec un moyen d'étanchéité souple sur tout le bord inférieur, destiné à être placé en appui étanche sur une surface périphérique (19') solidaire de la zone (A) à observer.

2. Ensemble selon la revendication 1, caractérisé en ce que des moyens (21) sont prévus pour mettre en communication la chambre intérieure (4) avec une installation de pompage (40).

3. Ensemble selon une des revendications 1 ou 2, caractérisé en ce que le moyen d'étanchéité souple comprend un joint (17) en matériau élastomère.

4. Ensemble selon une des revendications précédentes caractérisé en ce qu'il comprend des moyens de réglage en hauteur (18, 18') pour régler la distance entre l'extrémité inférieure de la colonne (1) et la surface à observer (A).

5. Ensemble selon une des revendications précédentes, caractérisé en ce que le support délimitant la chambre est relié de façon articulée (22) à la base de la colonne (1).

6. Ensemble selon la revendication 5, caractérisé en ce qu'il comporte une membrane souple étanche (23) reliant la partie supérieure du support (16) à la base de la colonne (1).

7. Ensemble selon l'une quelconque des revendications précédentes, caractérisé en ce qu'il comprend un détecteur d'électrons annulaire (14) monté à l'extrémité inférieure de la colonne 1, à l'intérieur de la chambre.

## Claims

1. An electronic microscope assembly with in situ operating sweep, provided with : a unit microscope column ; and connecting means to a microscope drive and control equipment and a pumping equipment, including means (16, 18) adapted to support said column (1), connected to the lower part thereof and forming a pressure-resisting internal chamber (4) having an open lower portion, with a resilient sealing means on the lower edge thereof, adapted to be tightly placed onto a peripheric surface (19') integral with the region (A) to be observed.

2. The assembly as recited in claim 1, wherein means (21) are provided to communicate said internal chamber (4) with a pumping equipment (40).

3. The assembly as recited in claim 1 or 2, wherein said resilient sealing means includes a gasket (17) made of elastomeric material.

4. The assembly as recited in any preceding claim, including means for height adjustment (18, 18') adapted to set the distance between the lower end of said column (1) and the surface to be observed (A).

5. The assembly as recited in any preceding claim, wherein said support for delimiting said chamber is hingedbly (22) connected to column (1) base.

6. The assembly as recited in claim 5, including a tight resilient diaphragm (23) connecting support (16) lower part to said column (1) base.

7. The assembly as recited in preceding claim, including an annular electron detector (14) provided at the lower end of column (1), inside said chamber.

**Patentansprüche**

1. Rasterelektronenmikroskopaufbau zum Gebrauch in situ mit : einem einstückigen Mikroskopgehäuse und mit Verbindungsanordnungen zu einer Steuer- und Kontrolleinrichtung für das Mikroskop und zu einer Evakuierungseinrichtung, dadurch gekennzeichnet, daß es eine Halteanordnung (16, 18) für das Gehäuse (1) aufweist, die mit dessen Unterteil verbunden ist und eine druckdichte Innenkammer (4) begrenzt, welche einen unteren offenen Abschnitt aufweist, mit einem weichen Abdichtmittel entlang des gesamten unteren Randes, das zum dichtenden Anliegen entlang des Umfangs einer mit dem zu beobachtenden Bereich (A) fest verbundenen Fläche (19') bestimmt ist.

2. Aufbau nach Anspruch 1, dadurch gekennzeichnet, daß eine Anordnung (21) vorgesehen ist um die Innenkammer (4) mit einer Evakuierungseinrichtung (40) zu verbinden.

3. Aufbau nach einem der Ansprüche 1 oder 2, dadurch gekennzeichnet, daß das weiche Abdichtmittel eine Dichtung (17) aus einem Elastomer aufweist.

4. Aufbau nach einem der vorhergehenden Ansprüche, dadurch gekennzeichnet, daß er eine Anordnung zur Höhenregelung (18, 18') aufweist um den Abstand zwischen dem unteren Ende des Gehäuses (1) und der zu beobachtenden Fläche (A) zu regeln.

5. Aufbau nach einem der vorhergehenden Ansprüche, dadurch gekennzeichnet, daß die die Kammer begrenzende Halterung gelenkig (22) mit dem Grundteil des Gehäuses (1) verbunden ist.

6. Aufbau nach Anspruch 5, dadurch gekennzeichnet, daß er eine dichte weiche Membran (23) aufweist, die den oberen Teil der Halterung (16) mit dem Grundteil des Gehäuses (1) verbindet.

7. Aufbau nach einem der vorhergehenden Ansprüche, dadurch gekennzeichnet, daß er einen ringförmigen elektronendetektor (14) aufweist, der am unteren Ende des Gehäuses (1) im Inneren der Kammer angeordnet ist.

# Fig : 1